# EUROPEAN PATENT SPECIFICATION

(11) **EP 1 018 669 B1**
(45) Date of publication and mention of the grant of the patent: **01.03.2006**
(21) Application number: 99310625.1
(22) Date of filing: 29.12.1999
(51) Int. Cl.: G03F 7/20

(54) **Projection lithography with servo control**
Projektionslithographie mit Servosteuerung
Lithographie par projection et avec servocommande

(30) Priority: 08.01.1999 EP 99200032
(43) Date of publication of application: 12.07.2000
(73) Proprietor: ASML Netherlands B.V., 5504 DR Veldhoven (NL)
(72) Inventor: Hultermans, Sebastiaan Cornelis, 5554 MJ Valkenswaard (NL)
(74) Representative: Leeming, John Gerard

(56) References cited:
- US-A- 4 993 696
- US-A- 5 623 853
- PATENT ABSTRACTS OF JAPAN vol. 1998, no. 03, 27 February 1998 (1998-02-27) & JP 09 289155 A (NIKON CORP), 4 November 1997 (1997-11-04) & US 5 986 743 A (HANZAWA TATSUO) 16 November 1999 (1999-11-16)

## Description

The present invention relates to servo control methods and apparatus. More specifically, the invention relates to the application of such methods and apparatus in a lithographic projection apparatus comprising:
- a radiation system for supplying a projection beam of radiation;
- a movable mask table provided with a mask holder for holding a mask, and connected to mask table positioning means;
- a movable substrate table provided with a substrate holder for holding a substrate, and connected to substrate table positioning means;
- a projection system for imaging an irradiated portion of the mask onto a target portion of the substrate.

Such an apparatus is known from US-A-5 623 853, on which is based the preamble of claim 1.

Lithographic projection apparatus can be used, for example, in the manufacture of integrated circuits (ICs). In such a case, the mask (reticle) may contain a circuit pattern corresponding to an individual layer of the IC, and this pattern can then be imaged onto a target area (die) on a substrate (silicon wafer) which has been coated with a layer of photosensitive material (resist). In general, a single wafer will contain a whole network of adjacent dies which are successively irradiated through the reticle, one at a time. In one type of lithographic projection apparatus, each die is irradiated by exposing the entire reticle pattern onto the die in one go; such an apparatus is commonly referred to as a waferstepper. In an alternative apparatus - which is commonly referred to as a step-and-scan apparatus - each die is irradiated by progressively scanning the reticle pattern through the projection beam in a given reference direction (the "scanning" direction) while synchronously scanning the wafer table parallel or anti-parallel to this direction; since, in general, the projection system will have a magnification factor M (generally < 1), the speed *v* at which the wafer table is scanned will be a factor M times that at which the reticle table is scanned. In both types of apparatus, after each die has been imaged onto the wafer, the wafer table can be "stepped" to a new position so as to allow imaging of a subsequent die. More information with regard to lithographic devices as here described can be gleaned from International Patent Applications WO 97/33205 and WO 96/38764, for example.

Up to very recently, apparatus of this type contained a single mask table and a single substrate table. However, machines are now becoming available in which there are at least two independently movable substrate tables; see, for example, the multi-stage apparatus described in International Patent Applications WO 98/28665 and WO 98/40791. The basic operating principle behind such multi-stage apparatus is that, while a first substrate table is underneath the projection system so as to allow exposure of a first substrate located on that table, a second substrate table can run to a loading position, discharge an exposed substrate, pick up a new substrate, perform some initial alignment measurements on the new substrate, and then stand by to transfer this new substrate to the exposure position underneath the projection system as soon as exposure of the first substrate is completed, whence the cycle repeats itself; in this manner, it is possible to achieve a substantially increased machine throughput, which in turn improves the cost of ownership of the machine.

The projection radiation in current lithographic devices is generally UV (ultraviolet) light with a wavelength of 365 nm, 248 nm or 193 nm. However, the continual shrinkage of design rules in the semiconductor industry is leading to an increasing demand for new radiation types. Current candidates for the near future include UV light with wavelengths of 157 nm or 126 nm, as well as extreme UV light (EUV) and particle beams (e.g. electron or ion beams).

In a lithographic projection apparatus, it is necessary to control the position of the wafer table and the reticle table to an extremely high degree of accuracy, throughout multiple exposures. Vibrations in these stages may be caused *inter alia* by floor vibrations, indirect stepping forces, air mount noise or acoustic noise. Such vibrations reduce the image quality of the exposure; however, if operation of the system is paused so as to allow the vibrations to fade away between each exposure, this generally causes an undesirable reduction in throughput.

A particularly important characteristic of a lithographic projection apparatus is its so-called overlay precision. In a typical projection procedure, each target portion of the substrate will be subjected to various exposures, in successive irradiation sessions. These exposures will typically result in patterned layers (*e*.*g*. the circuit patterns in the various semiconductor layers of an IC) which will have to be accurately overlapped with one another. The overlay precision expresses the accuracy with which such overlap can be reproducibly achieved, and it is often of the order of nanometers. Vibrations from various sources can be transferred *inter alia* to the mask and substrate tables, where they can have a highly detrimental effect on the achievement of the required overlay accuracy.

It should be noted that, whilst it is relatively easy to detect the existence of vibrations as hereabove described, it requires considerable work to identify and eliminate their sources.

It is an object of the invention to address and alleviate this problem. In particular, it is an object of the invention to provide an apparatus as specified in the opening paragraph, suffering from reduced vibration-related positioning errors.

These and other objects are achieved according to the present invention in a lithographic projection apparatus according to claim 1.

The term "conduit" as here employed refers to the "umbilical cord" which generally connects at least one of the movable tables to the outside frame (e.g. a metrology frame) and which carries such items as power cords, signal carriers, air tubes (e.g. for supplying air to an air bearing in the table), coolant tubes, *etc*. The mask table and/or the substrate table may be connected to an outside frame in this manner (using a distinct conduit for each table); consequently, the term "first table" as here employed generally encompasses both the mask table and the substrate table.

In experiments leading to the invention, the inventors performed investigations with a test lithographic apparatus, and concentrated on the achievable overlay precision with that apparatus. Although the measured precision was relatively satisfactory in the light of current standards in the semiconductor industry, it matched less satisfactorily with the standards expected to be introduced in the near future (as projection wavelengths decrease and feature sizes continue to shrink). Consequently, methods were sought to improve the attainable overlay. After much experimentation, it was eventually observed that the conduit between the substrate table and the outside world was an important source of table vibration. This phenomenon was initially tackled by attempting a redesign of the conduit (different materials, different dimensions, different forms, *etc.*), but the results of such redesigns were rather disappointing. Eventually, having realized that the phenomenon could not be alleviated in this manner, the inventors adopted an alternative approach: that of measurement and compensation instead of removal. This approach resulted in the current invention.

The present invention also provides a method of controlling the position of a movable table in a lithographic projection apparatus in which a flexible conduit connects the said table to a frame outside the table according to claim 9.

The feedforward control provided by the present invention can provide a substantial improvement in the positioning accuracy of a movable table (e.g. a wafer table), and particularly the repeatability of positioning, by substantially compensating for the effects of vibrations caused by the presence and motion of the conduit .

In a manufacturing process using a lithographic projection apparatus according to the invention, a pattern in a mask is imaged onto a substrate which is at least partially covered by a layer of energy-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, *e.g.* an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, *etc.* Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, *etc.* The skilled artisan will appreciate that, in the context of such alternative applications, any use of the terms "reticle", "wafer" or "die" in this text should be considered as being replaced by the more general terms "mask", "substrate" and "target area", respectively.

The present invention will be described below with reference to exemplary embodiments and the accompanying schematic drawings, in which:
Fig. 1 depicts a lithographic projection apparatus according to the invention;
Fig. 2 is a diagram of relevant components of a lithographic projection apparatus to which the present invention is applied;
Fig. 3 is an enlarged partly sectional view showing a possible mounting of the force sensor;
Fig. 4 is a block diagram of a control system according to the present invention.
In the figures, like reference symbols indicate like parts.

### Embodiment 1

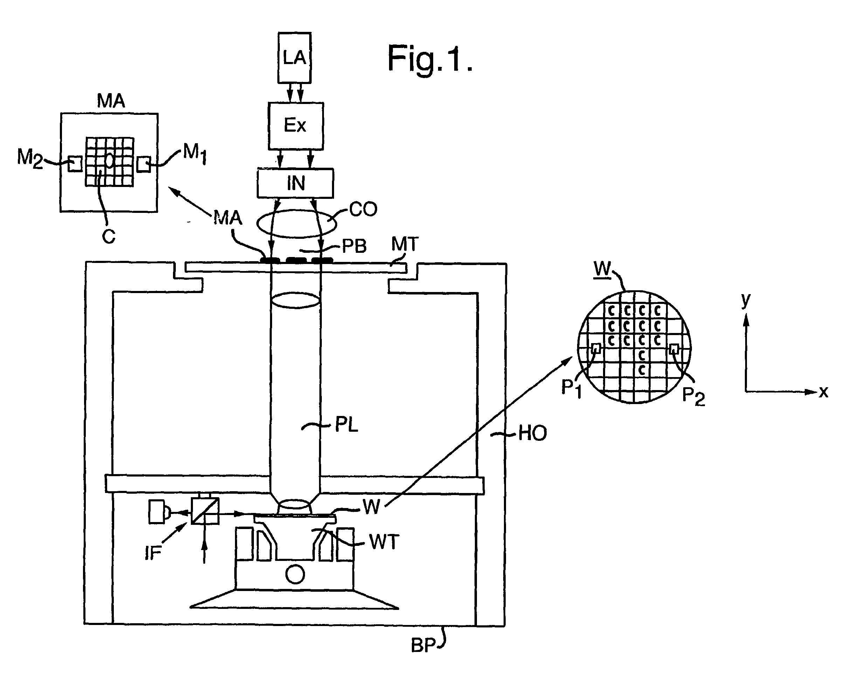

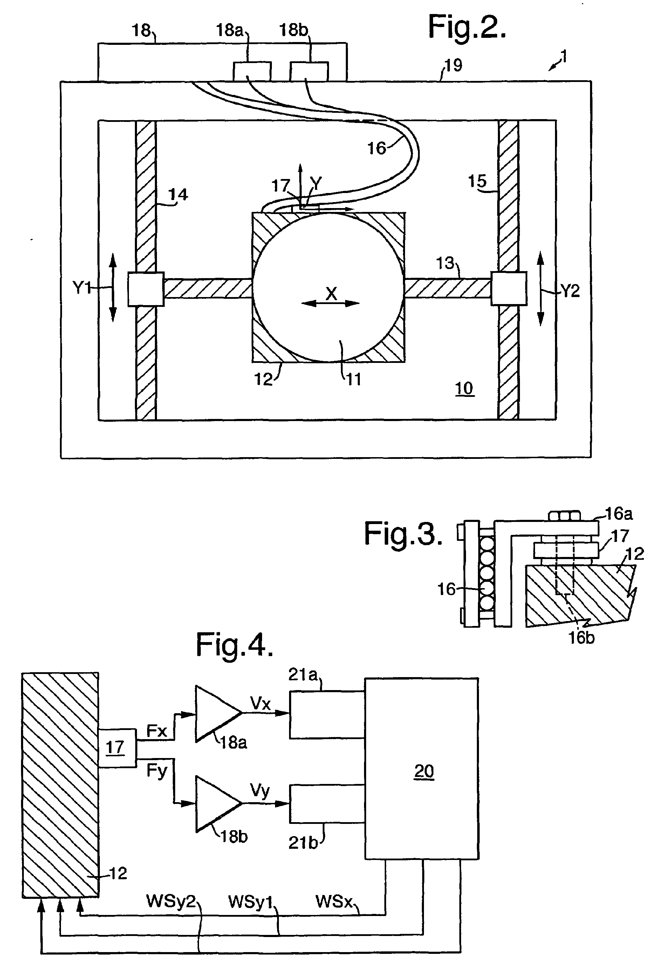

Figure 1 schematically depicts a lithographic projection apparatus according to the invention. The apparatus comprises:
- a radiation system LA, Ex, IN, CO for supplying a projection beam PB of radiation (*e.g.* UV or EUV radiation, electrons or ions);
- a movable mask table (reticle table) MT provided with a mask holder for holding a mask (reticle) MA, and connected to mask table positioning means PM for accurately positioning the mask with respect to item PL;
- a movable substrate table (wafer table) WT provided with a substrate holder for holding a substrate W (*e.g.* a resist-coated silicon wafer), and connected to substrate table positioning means PW for accurately positioning the substrate with respect to item PL;
- a projection system PL (e.g. a refractive or catadioptric system, a mirror group or an array of field deflectors) for imaging an irradiated portion of the mask MA onto a target portion C (die) of the substrate W. For simplicity, item PL may be referred to as the "lens".
The positioning means PM and PW are not explicitly depicted in Figure 1, but may be of a type as depicted in Figure 2 and explained in Embodiment 2, for example. As here depicted, the lithographic projection apparatus is transmissive, *i.e.* it has a transmissive reticle and purely refractive lens; however, the apparatus may also be (at least partially) reflective, for example.

The radiation system comprises a source LA (e.g. a Hg lamp or excimer laser, a source of EUV such as an undulator provided around the path of a particle beam from an accelerator, or an electron or ion gun) which produces a beam of radiation. This beam is passed along various optical components, - *e*.*g*. beam shaping optics Ex, an integrator IN and a condensor CO - so that the resultant beam PB has a desired form and intensity distribution in its cross-section.

The beam PB subsequently intercepts the mask MA which is held in a mask holder on the mask table MT. Having traversed the mask MA, the beam PB passes through the lens PL, which focuses the beam PB onto a target area C of the substrate W. With the aid of the interferometric displacement and measuring means PW, the substrate table WT can be moved accurately, e.g. so as to position different target areas C in the path of the beam PB. Similarly, the positioning means PM can be used to accurately position the mask MA with respect to the path of the beam PB, e.g. after mechanical retrieval of the mask MA from a mask library. In general, movement of the tables MT, WT will be realized with the aid of a long stroke module (course positioning) and a short stroke module (fine positioning), which are not explicitly depicted in Figure 1.

The depicted apparatus can be used in two different modes:
- In step mode, the mask table MT is kept essentially stationary, and an entire mask image is projected in one go (*i.e.* a single "flash") onto a target area C. The substrate table WT is then shifted in the X and/or Y directions so that a different target area C can be irradiated by the beam PB;
- In scan mode, essentially the same scenario applies, except that a given target area C is not exposed in a single "flash". Instead, the mask table MT is movable in a given direction (the so-called "scan direction", *e.g.* the Y direction) with a speed *v*, so that the projection beam PB is caused to scan over a mask image; concurrently, the substrate table WT is simultaneously moved in the same or opposite direction at a speed *V = Mv*, in which *M* is the magnification of the lens PL (typically, *M* = 1/4 or 1/5). In this manner, a relatively large target area C can be exposed, without having to compromise on resolution.

Vibrations from various sources can be transferred *inter alia* to the tables MT, WT, where they can have a highly detrimental effect on the achievement of the required overlay accuracy. The present invention can be used to alleviate this problem, e.g. as described in Embodiment 2.

### Embodiment 2

Figure 2 is a schematic diagram of the relevant components of a stepper-type lithographic projection apparatus ("lithography device") 1 to which the present invention is applied. As shown in figure 2, a granite stone 10 provides support for the movable wafer table ("chuck") 12, which in turn supports the wafer 11 which is to be exposed by the lithography device. The chuck 12, when operating, floats over the stone 10 on an air bearing, and can be positioned under the projection lens of the apparatus by three linear motors arranged in an H-configuration. X-motor 13 controls the position of the chuck 12 in the X-direction, whilst Y1-motor 14 and Y2-motor 15 are independently moveable along Y1 and Y2 axes, which are substantially orthogonal to the X-direction, to position the chuck 12 both in the Y-direction and rotationally (Rz). Each of the three motors 13, 14 and 15 operates, for example, on the basis of Lorentz forces and according to well established principles, and comprises:
- an elongate track (stator) which is provided with a "herringbone" pattern of permanent-magnet segments, and;
- a movable "rider" which is provided with a system of field coils and can slide along the said track in response to the passage of electrical currents through the field coils.
Short-stroke actuators for fine positioning of the chuck 12 in at least X, Y and Rz are provided between the chuck 12 and the stone 10, and are not explicitly depicted in Figure 2.

A conduit ("cable slab" or "umbilical cord") 16 connects the chuck 12 to terminal block 18, which is mounted on the metrology frame 19. The cable slab 16 provides conduits *inter alia* for compressed air, coolant, electrical power cables and signal cables. As the chuck 12 moves about on the stone 10, the cable slab 16 folds and unfolds to follow its movements.

The present inventors have determined that particularly troublesome vibrations in a frequency-range 4-18 Hz are caused by the cable slab 16 as it settles into a new position after each movement of the chuck 12. A force sensor ("force sensing means"), or load cell, 17 is therefore provided in the mounting on the chuck 12 to which the cable slab 16 is connected, and its output used to generate compensatory forces that are applied to the chuck 12 *via* the linear motors 13, 14 and 15. Output signals from the force sensor are carried by coaxial cables included in the cable slab 16.

The magnitude of the forces to be detected will depend on the actual application, and particularly the size and shape of the cable slab 16. In this embodiment, the force sensor should be capable of detecting forces in the range 0.1-20 N with an accuracy of 10 mN and over a frequency range of 1 to 50 Hz. A suitable example of a force sensor usable in the invention is the Quartz sensor ref 9251A manufactured by Kistler Instrumente AG of Switzerland; this sensor can measure rotational forces about the Z axis as well, but this channel may not be necessary in certain applications. Alternative sensors for use according to the invention are the model Delta 330/30 sensor supplied by the firm ATI Industrial Automation, and the model FGP bi-directional miniature force transducer supplied by the firm J&M, for example.

As shown in Figure 3, the force sensor 17 is bolted directly between the chuck 12 and the bracket 16a that clamps the end of the cable slab 16. In this manner, the force sensor 17 can give a direct indication of the forces exerted on the chuck 12 by the cable slab 16. The very high mechanical stiffness of the sensor assembly allows very accurate measurement of forces exerted on the upper part of the mounting bolt, and the upper part of the load cell (in the sense as depicted in Figure 3).

The control system for generation of the control signals is shown in block form in Figure 4.

Output signals Fx and Fy, which represent the forces in the X- and Y-directions detected by the force sensor 17, are supplied to load amplifiers 18a and 18b located in the terminal block 18, as shown in Figure 2. If, as in this case, the force sensor is of the piezoelectric type, the output signals will be charge signals, and these are converted into voltage signals Vx and Vy in the load amplifiers 18a, 18b. The load amplifiers 18a, 18b are situated in the terminal block 18 to minimize the effect of electrical noise picked up by the sensor leads, whilst avoiding placing any unnecessary weight on the chuck 12. The remainder of the control system may be situated more remotely from the wafer table.

X- and Y- motion controllers 21a, 21b receive the voltage signals Vx and Vy, and generate appropriate compensating motions to be applied to the chuck 12. The stepper controller 20 combines these signals with other control signals relating to other desired motions of the chuck 12, and combined wafer table control signals WSx, WSy1 and WSy2 are outputted to the linear motors 13, 14 and 15. Low-pass filters with a cut-off of 30 Hz, for example, are provided in the input to the controllers 21a, 21b, so to eliminate any higher-frequency components that may have been generated by electrical noise rather than actual physical movements.

Trials with the invention have shown that it can reduce maximum "DY errors", which represent the accuracy with which the wafer can be returned to the same position for multiple exposures. Without application of the invention, a reference sample of three wafers in a test apparatus exhibited DY errors of 19.2 to 24.9 nm at an equivalent wafer throughput of 88 wafers per hour. With the invention, maximum DY errors were reduced to between 12.4 and 13.5 nm.

As illustrated, the force sensor detects only forces in the X and Y directions; however a sensor measuring rotational forces about the Z axis (Rz forces) may also be provided. In that case, an additional load amplifier and motion controller will be provided. If necessary, conversion between the X-Y-Rz coordinate system and the X-Y1-Y2 coordinate system can be carried out either in the motion controllers 21a, 21b or in the stepper controller 20.

This embodiment of the invention uses a single sensor to measure forces in both the X and Y directions. Alternatively, separate sensors may be provided. Forces on three axes may similarly be measured using separate X, Y and Rz sensors or X, Y1 and Y2 sensors.

The arrangement illustrated in Figure 2 is particularly suitable for use as (part of) a wafer stage in a lithographic projection apparatus. In the case of a reticle stage for use with a transmissive reticle, the chuck 12 and stone 10 will have to contain a suitable aperture, in order to allow the transmission of projection radiation through the stage (from the radiation system to the projection system). For application in a stepper, such a reticle stage will generally not require the motors 13, 14 and 15, since short-stroke motion of the chuck 12 will generally be sufficient. On the other hand, in the case of a step-and-scan device, the motors 14 and 15 will be sufficient for long-stroke actuation in the Y-direction (scan direction), and the long-stroke motor 13 will generally be unnecessary (since only short-stroke actuation in X will generally be required).

## Claims

1. A lithographic projection apparatus comprising:
- a radiation system (LA, Ex, IN, CO) for supplying a projection beam (PB) of radiation;
- a movable mask table (MT) provided with a mask holder for holding a mask (MA),
- mask table positioning means connected to said movable mask table (MT);
- a movable substrate table (WT) provided with a substrate holder for holding a substrate (W);
- substrate table positioning means connected to said movable substrate table (WT);
- a projection system (PL) for imaging an irradiated portion of the mask (MA) onto a target portion (C) of the substrate (W);
- a frame (19);
- a flexible conduit (16) which connects at least a first of the movable tables (MT, WT) to said frame (19), said frame being outside that table,
**characterized by**:
- a force sensor (17) arranged to measure forces exerted on the said first table (MT, WT) by the flexible conduit (16) and to generate a force signal (Fx, Fy) representative of said forces; and
- a motion controller (21 a, 21 b) responsive to said force signal (Fx, Fy) and arranged to generate control signals (WSx, WSy1, WSy2) to cause the positioning means (13, 14, 15) connected to the said first table (MT, WT) to apply compensatory forces to said first table (MT, WT) so as to counteract the effects of said forces exerted by the conduit (16) on the table (MT, WT).

2. An apparatus according to claim 1, wherein the said first table (MT, WT) is movable along at least two displacement axes, and the force sensor (17) is adapted to detect forces acting in at least two force axes.

3. An apparatus according to claim 2, wherein said two force axes are substantially orthogonal.

4. An apparatus according to claim 1, 2 or 3, further comprising a low-pass filter for low-pass filtering the force signal outputted by the force sensor.

5. An apparatus according to claim 4, wherein the low-pass filter has a cut-off frequency in the range 20-40 Hz.

6. An apparatus according to any of the preceding claims, wherein the force sensor (17) is a piezo-electric sensor, further comprising at least one load amplifier (18a, 18b) for converting a charge signal, outputted by the force sensor as the said force signal (Fx, Fy), into a voltage signal (Vx, Vy).

7. An apparatus according to any of the preceding claims, wherein said conduit (16) comprises at least one channel selected from the group comprising: a compressed air supply channel, a coolant supply channel, an electrical power supply channel, a control signal channel, and a sensor signal channel.

8. An apparatus according to any of the preceding claims, further comprising a bracket (16a) for mounting an end of said conduit (16) to the said first table (MT, WT), and wherein the force sensor (17) is mounted between said bracket and the said first table.

9. A method of controlling the position of a movable table (MT, WT) in a lithographic projection apparatus in which a flexible conduit (16) connects the said table (MT, WT) to a frame (19) outside the table, the method being **characterized by** the steps of:
- measuring forces exerted on the table (MT, WT) by the conduit (16);
- generating a force signal (Fx, Fy) representative of said forces;
- in response to said force signal (Fx, Fy) generating control signals (WSx, WSy1, WSy2) indicative of compensatory forces to be applied to the table (MT, WT); and
- applying compensatory forces to the table (MT, WT) in response to said control signals (WSx, WSy1, WSy2), so as to counteract the effects of said forces exerted by the conduit (16) on the table (MT, WT).

10. A method according to claim 9, wherein said forces exerted on said table (MT, WT) are measured in at least two substantially orthogonal directions.

11. A device manufacturing method comprising the steps of:
- providing a substrate (W) that is at least partially covered by a layer of radiation-sensitive material;
- providing a mask (MA) which contains a pattern;
- using a projection beam (PB) of radiation to project an image of at least part of the mask (MA) pattern onto a target area of the layer of radiation-sensitive material, whereby at least one of the substrate (W) and the mask (MA) is held on a movable object table (MT, WT) that is connected to positioning means (13, 14, 15), and is also connected to a frame (19) outside the table *via* a conduit (16),
whereby the position of the moveable object table (MT WT), is controlled in accordance with the method claimed in claim 9 or claim 10;
whereby a force sensor (17) is used to measure said forces exerted on the object table (MT, WT) by the conduit (16), and to generate the force signal (Fx, Fy) representative of said forces; and
whereby a motion controller (21 a, 2 1 b) responsive to said force signal (Fx, Fy) is used to generate said control signals (WSx, WSy1, WSy2) to cause the said positioning means (13,14, 15) to apply compensatory forces to the object table (MT, WT).

## Patentansprüche

1. Lithographischer Projektionsapparat, der umfasst:
ein Strahlungssystem (LA, Ex, IN, CO) zum Liefern eines aus Strahlung bestehenden Projektionsstrahles (PB);
einen beweglichen Maskentisch (MT), der einen Maskenhalter zum Halten einer Maske (MA) aufweist;
mit dem beweglichen Maskentisch (MT) verbundene Maskentisch-Positionierungsmittel;
einen beweglichen Substrattisch (WT), der einen Substrathalter zum Halten eines Substrats (W) aufweist;
mit dem beweglichen Substrattisch (WT) verbundene Substrattisch-Positionierungsmittel;
ein Projektionssystem (PL) zum Abbilden eines bestrahlten Abschnitts der Maske (MA) auf einen Zielabschnitt (C) des Substrats (W);
einen Rahmen (19);
eine flexible Leitung (16), die wenigstens einen ersten der beweglichen Tische (MT, WT) mit dem Rahmen (19) verbindet, wobei sich der Rahmen außerhalb dieses Tisches befindet,
**gekennzeichnet durch**:
einen zum Messen von **durch** die flexible Leitung (16) auf den ersten Tisch (MT, WT) ausgeübten Kräften und zum Erzeugen eines für die Kräfte repräsentativen Kraftsignals (Fx, Fy) angeordneten Kraftsensor (17); und
eine auf das Kraftsignal (Fx, Fy) ansprechende Bewegungssteuerung (21a, 21b), die zum Erzeugen von Steuersignalen (WSx, WSy1, WSy2) angeordnet ist, um die mit dem ersten Tisch (MT, WT) verbundenen Positionierungsmittel (13, 14, 15) zur Ausübung von Ausgleichskräften auf den ersten Tisch (MT, WT) zu veranlassen, um den Wirkungen der von der Leitung (16) auf den Tisch (MT, WT) ausgeübten Kräften entgegenzuwirken.

2. Apparat nach Anspruch 1, wobei der erste Tisch (MT, WT) wenigstens zwei Versatzachsen entlang beweglich ist und der Kraftsensor (17) in wenigstens zwei Kraftachsen wirkende Kräfte zu erfassen vermag.

3. Apparat nach Anspruch 2, wobei die zwei Kraftachsen im Wesentlichen senkrecht zueinander sind.

4. Apparat nach Anspruch 1, 2 oder 3, der ferner einen Tiefpassfilter zum Tiefpassfiltern des vom Kraftsensor ausgegebenen Kraftsignals umfasst.

5. Apparat nach Anspruch 4, wobei der Tiefpassfilter eine Grenzfrequenz im Bereich von 20 - 40 Hz aufweist.

6. Apparat nach einem der vorhergehenden Ansprüche, wobei der Kraftsensor (17) ein piezoelektrischer Sensor ist, ferner wenigstens einen Lastverstärker (18a, 18b) zum Umwandeln eines vom Kraftsensor als das Lastsignal (Fx, Fy) ausgegebenen Ladungssignals in ein Spannungssignal (Vx, Vy) umfassend.

7. Apparat nach einem der vorhergehenden Ansprüche, wobei die Leitung (16) wenigstens einen Kanal umfasst, der aus der Gruppe ausgewählt ist, die umfasst: einen Druckluftversorgungskanal, einen Kühlmittelversorgungskanal, einen Stromversorgungskanal, einen Steuersignalversorgungskanal und einen Sensorsignalkanal.

8. Apparat nach einem der vorhergehenden Ansprüche, der ferner eine Halterung (16a) zum Befestigen eines Endes der Leitung (16) am ersten Tisch (MT, WT) umfasst, und wobei der Kraftsensor (17) zwischen der Halterung und dem ersten Tisch befestigt ist.

9. Verfahren zum Steuern der Position eines beweglichen Tisches (MT, WT) in einem lithographischen Projektionsapparat, bei dem eine flexible Leitung (16) den Tisch (MT, WT) mit einem Rahmen (19) außerhalb des Tisches verbindet, wobei das Verfahren **gekennzeichnet ist durch** die Schritte:
Messen von **durch** die Leitung (16) auf den Tisch (MT, WT) ausgeübten Kräften;
Erzeugen eines für die Kräfte repräsentativen Kraftsignals (Fx, FX);
Erzeugen von auf Ausgleichskräfte, die auf den Tisch (MT, WT) auszuüben sind, hinweisenden Steuersignalen (WSx, WSy1, WSy2) als Reaktion auf das Kraftsignal (Fx, Fy); und
Ausüben von Ausgleichskräften auf den Tisch (MT, WT) als Reaktion auf die Steuersignale (WSx, WSy1, WSy2), um den Wirkungen der von der Leitung (16) auf den Tisch (MT, WT) ausgeübten Kräften entgegenzuwirken.

10. Verfahren nach Anspruch 9, wobei die auf den Tisch (MT, WT) ausgeübten Kräfte in wenigstens zwei im Wesentlichen senkrecht zueinander verlaufenden Richtungen gemessen werden.

11. Ein Geräteherstellungsverfahren, das die Schritte umfasst:
Vorsehens eines Substrats (W), das wenigstens teilweise mit einer Schicht aus strahlungsempfindlichem Material bedeckt ist;
Vorsehen einer ein Muster enthaltenden Maske (MA);
Verwenden eines aus Strahlung bestehenden Projektionsstrahles(PB) zum Projizieren eines Abbildes von wenigstens eines Teils des Musters der Maske (MA) auf einen Zielbereich der Schicht aus strahlungsempfindlichem Material, bei dem wenigstens das Substrat (W) oder die Maske (MA) an einem beweglichen Objekttisch (MT, WT) gehalten wird, der mit Positionierungsmitteln (13, 14, 15) verbunden ist und auch über eine Leitung (16) mit einem Rahmen (19) außerhalb des Tisches verbunden ist;
bei dem die Position des beweglichen Objekttisches (MT, WT) gemäß dem in Anspruch 9 oder Anspruch 10 beanspruchten Verfahren gesteuert wird;
bei dem ein Kraftsensor (17) zum Messen der durch die Leitung (16) auf den Objekttisch (MT, WT) ausgeübten Kräfte und zum Erzeugen des für die Kräfte repräsentativen Kraftsignals (Fx, Fy) verwendet wird; und
bei dem eine auf das Kraftsignal (Fx, Fy) ansprechende Bewegungssteuerung (21a, 21b) zum Erzeugen der Steuersignale (WSx, WSy1, WSy2) verwendet wird, um die Positionierungsmittel (13, 14, 15) zum Ausüben von Ausgleichskräften auf den Objekttisch (MT, WT) zu veranlassen.

## Revendications

1. Appareil de projection lithographique comportant :
- un système de rayonnement (LA, Ex, IN, CO) pour délivrer un faisceau de projection (PB) de rayonnement ;
- une table de masque mobile (MT) munie d'un support de masque pour supporter un masque (MA),
- des moyens de positionnement de table de masque connectés à ladite table de masque mobile (MT) ;
- une table de substrat mobile (WT) munie d'un support de substrat pour supporter un substrat (W) ;
- des moyens de positionnement de table de substrat connectés à ladite table de substrat mobile (WT) ;
- un système de projection (PL) pour produire une image d'une partie irradiée du masque (MA) sur une partie cible (C) du substrat (W) ;
- un châssis (19) ;
- un conduit flexible (16) qui connecte au moins une première des tables mobiles (MT, WT) audit châssis (19), ledit châssis étant à l'extérieur de cette table,
**caractérisé par** :
- un capteur de forces (17) conçu pour mesurer des forces exercées sur ladite première table (MT, WT) par le conduit flexible (16) et générer un signal de forces (Fx, Fy) représentatif desdites forces ; et
- un contrôleur de mouvement (21a, 21b) sensible audit signal de forces (Fx, Fy) et conçu pour générer des signaux de commande (WSx, WSy1, WSy2) pour amener les moyens de positionnement (13, 14, 15) connectés à ladite première table (MT, WT) à appliquer des forces compensatrices à ladite première table (MT, WT) de manière à contrecarrer les effets desdites forces exercées par le conduit (16) sur la table (MT, WT).

2. Appareil selon la revendication 1, dans lequel ladite première table (MT, WT) est mobile le long d'au moins deux axes de déplacement, et le capteur de forces (17) est adapté pour détecter des forces agissant dans au moins deux axes de force.

3. Appareil selon la revendication 2, dans lequel lesdits deux axes de force sont sensiblement orthogonaux.

4. Appareil selon la revendication 1, 2 ou 3, comportant de plus un filtre passe-bas pour un filtrage passe-bas du signal de forces délivré en sortie par le capteur de forces.

5. Appareil selon la revendication 4, dans lequel le filtre passe-bas a une fréquence de coupure dans la plage de 20 à 40 Hz.

6. Appareil selon l'une quelconque des revendications précédentes, dans lequel le capteur de forces (17) est un capteur piézoélectrique, comportant de plus au moins un amplificateur d'effort (18a, 18b) pour convertir un signal de charge, délivré en sortie par le capteur de forces en tant que ledit signal de force (Fx, Fy), en un signal de tension (Vx, Vy).

7. Appareil selon l'une quelconque des revendications précédentes, dans lequel ledit conduit (16) comporte au moins un canal sélectionné parmi le groupe comportant : un canal d'alimentation d'air comprimé, un canal d'alimentation de fluide de refroidissement, un canal d'alimentation de courant électrique, un canal de signal de commande, et un canal de signal de capteur.

8. Appareil selon l'une quelconque des revendications précédentes, comportant de plus un étrier (16a) pour monter une extrémité dudit conduit (16) sur ladite première table (MT, WT), et dans lequel le capteur de forces (17) est monté entre ledit étrier et ladite première table.

9. Procédé pour commander la position d'une table mobile (MT, WT) dans un appareil de projection lithographique dans lequel un conduit flexible (16) connecte ladite table (MT, WT) à un châssis (19) à l'extérieur de la table, le procédé étant **caractérisé par** les étapes consistant à :
- mesurer des forces exercées sur la table (MT, WT) par le conduit (16) ;
- générer un signal de forces (Fx, Fy) représentatif desdites forces ;
- en réponse audit signal de forces (Fx, Fy), générer des signaux de commande (WSx, WSy1, WSy2) représentatifs de forces compensatrices à appliquer à la table (MT, WT) ; et
- appliquer des forces compensatrices à la table (MT, WT) en réponse auxdits signaux de commande (WSx, WSy1, WSy2) de manière à contrecarrer les effets desdites forces exercées par le conduit (16) sur la table (MT, WT).

10. Procédé selon la revendication 9, dans lequel lesdites forces exercées sur ladite table (MT, WT) sont mesurées dans au moins deux directions sensiblement orthogonales.

11. Procédé de fabrication d'un dispositif comportant les étapes consistant à :
- prévoir un substrat (W) qui est au moins partiellement recouvert d'une couche de matériau sensible au rayonnement ;
- prévoir un masque (MA) qui contient un motif ;
- utiliser un faisceau de projection (PB) de rayonnement pour projeter une image d'au moins une partie du motif de masque (MA) sur une zone cible de la couche de matériau sensible au rayonnement,
de sorte qu'au moins l'un parmi le substrat (W) et le masque (MA) est maintenu sur une table d'objet mobile (MT, WT) qui est connectée à des moyens de positionnement (13, 14, 15), et également est connectée à un châssis (19) à l'extérieur de la table via un conduit (16),
de sorte que la position de la table d'objet mobile (MT, WT) est commandée conformément au procédé selon la revendication 9 ou la revendication 10 ;
de sorte qu'un capteur de forces (17) est utilisé pour mesurer lesdites forces exercées sur la table d'objet (MT, WT) par le conduit (16), et pour générer le signal de forces (Fx, Fy) représentatif desdites forces ; et
de sorte qu'un contrôleur de mouvement (21a, 21b) sensible audit signal de forces (Fx, Fy) est utilisé pour générer lesdits signaux de commande (WSx, WSy1, WSy2) pour amener lesdits moyens de positionnement (13, 14, 15) à appliquer des forces compensatrices à la table d'objet (MT, WT).
